(19) Europäisches Patentamt
European Patent Office
Office européen des brevets

(11) **EP 4 096 369 A1**

(12) **EUROPEAN PATENT APPLICATION**
published in accordance with Art. 153(4) EPC

(43) Date of publication:
**30.11.2022 Bulletin 2022/48**

(21) Application number: **21744532.9**

(22) Date of filing: **22.01.2021**

(51) International Patent Classification (IPC):
*H05K 1/03* (2006.01)      *H05K 1/09* (2006.01)

(52) Cooperative Patent Classification (CPC):
**H05K 1/03; H05K 1/09**

(86) International application number:
**PCT/JP2021/002185**

(87) International publication number:
**WO 2021/149789 (29.07.2021 Gazette 2021/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.01.2020 JP 2020009305**

(71) Applicant: **Denka Company Limited**
**Tokyo 103-8338 (JP)**

(72) Inventors:
• **YUASA, Akimasa**
**Tokyo 103-8338 (JP)**
• **NAKAMURA, Takahiro**
**Tokyo 103-8338 (JP)**
• **ESHIMA, Yoshiyuki**
**Tokyo 103-8338 (JP)**
• **KOBASHI, Seiji**
**Tokyo 103-8338 (JP)**
• **NISHIMURA, Koji**
**Tokyo 103-8338 (JP)**

(74) Representative: **Gulde & Partner**
**Patent- und Rechtsanwaltskanzlei mbB**
**Wallstraße 58/59**
**10179 Berlin (DE)**

(54) **CERAMIC-COPPER COMPOSITE AND METHOD FOR PRODUCING CERAMIC-COPPER COMPOSITE**

(57)      A ceramic-copper composite (100) of the present invention is a ceramic-copper composite (100) having a flat plate shape, including: a ceramic layer (1); a copper layer (2); and a brazing material layer (3) which is interposed between the ceramic layer (1) and the copper layer (2) and contains Ag and Sn or In, in which an uneven portion is formed on a copper layer (2) side of the brazing material layer (3), and a plurality of Cu-rich phases (4) are present in a state of being separated from each other in at least one projecting portion (6).

FIG.3

100

EP 4 096 369 A1

## Description

TECHNICAL FIELD

The present invention relates to a ceramic-copper composite and a method for producing a ceramic-copper composite.

BACKGROUND ART

Various developments have been made on a ceramic-copper composite. As such a technique, for example, a technique disclosed in Patent Document 1 has been known. Patent Document 1 discloses bonding conditions for performing heat treatment at a temperature of 800°C for 15 minutes in a vacuum atmosphere in a state in which a Cu plate is pressed on and brought into contact with each of both front and back surfaces of an aluminum nitride substrate on which a brazing material paste is printed in a method for producing a ceramic circuit board (Patent Document 1, paragraph 0034 and the like).

RELATED DOCUMENT

PATENT DOCUMENT

[Patent Document 1] Japanese Unexamined Patent Publication No. 2005-101415

SUMMARY OF THE INVENTION

TECHNICAL PROBLEM

However, as a result of examination by the present inventor, it has been found that there is room for improvement in heat cycle characteristics of the ceramic-copper composite disclosed in Patent Document 1.

SOLUTION TO PROBLEM

As a result of further examination by the present inventor, it has been found that the heat cycle characteristics of the ceramic-copper composite are improved by forming a plurality of Cu-rich phases in a region of a brazing material layer which becomes convex toward a copper layer side, whereby the present invention has been accomplished.

According to the present invention, provided is a ceramic-copper composite having a flat plate shape, including: a ceramic layer; a copper layer; and a brazing material layer which is interposed between the ceramic layer and the copper layer and contains Ag and Sn or In, in which, in at least one of cut surfaces obtained when the ceramic-copper composite is cut along a plane perpendicular to a main surface of the ceramic-copper composite, an uneven portion is formed on a copper layer side of the brazing material layer, and a plurality of Cu-rich phases are present in a state of being separated from each other in at least one projecting portion.

In addition, according to the present invention, provided is a method for producing a ceramic-copper composite having a flat plate shape and including a ceramic layer, a copper layer, and a brazing material layer which is interposed between the ceramic layer and the copper layer and contains Ag, the method including: a step of preparing a flat plate-shaped laminate in which the ceramic layer, a brazing material containing Ag, and the copper layer are laminated; and a bonding step of heating the laminate at a temperature of 750°C or higher and 900°C or lower after raising a temperature at a temperature rising rate of 20 °C/min or higher and 150 °C/min or lower under a nitrogen atmosphere.

ADVANTAGEOUS EFFECTS OF INVENTION

According to the present invention, a ceramic-copper composite having excellent heat cycle characteristics and a method for producing the same are provided.

BRIEF DESCRIPTION OF THE DRAWINGS

Fig. 1 is a cross-sectional view of bonding of an outer portion in an example of a ceramic-copper composite according to the present embodiment.

Fig. 2 is an enlarged view of an α region of Fig. 1.
Fig. 3 is an enlarged view of a β region of Fig. 2.
Fig. 4 is an SEM image of a ceramic-copper composite of Example 1.

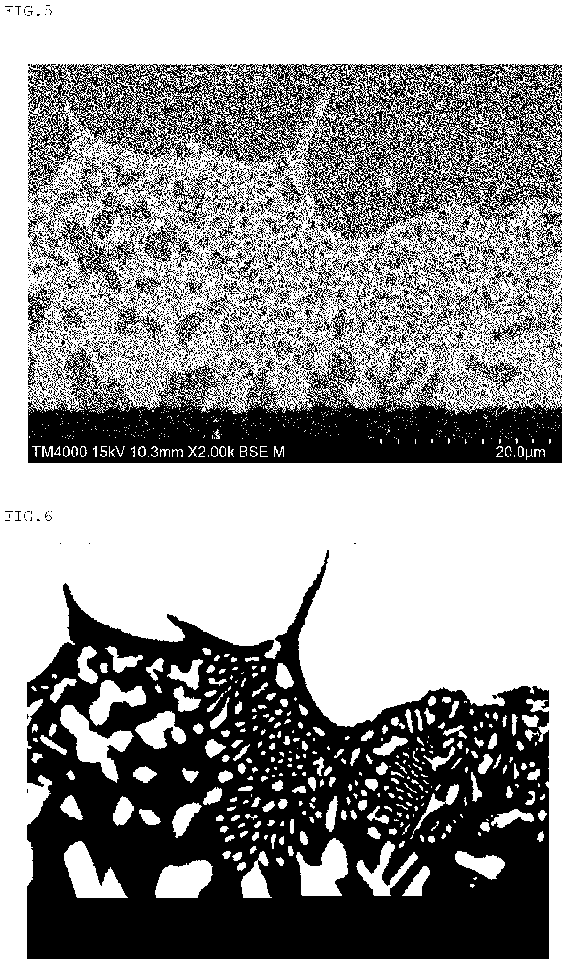

Fig. 5 is an SEM image of the ceramic-copper composite of Example 1.
Fig. 6 is a binarized view of the SEM image of the ceramic-copper composite of Example 1.

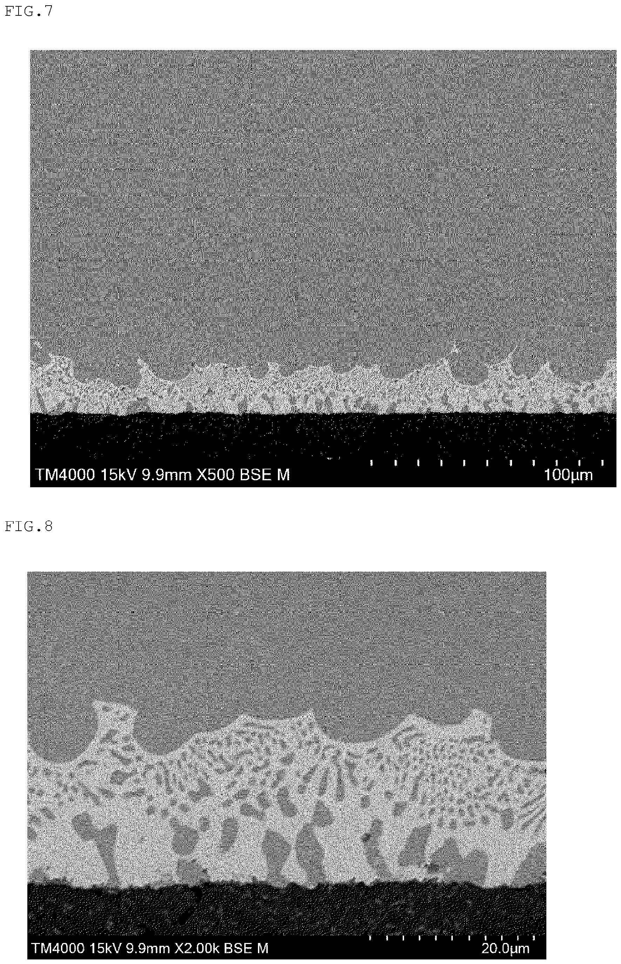

Fig. 7 is an SEM image of a ceramic-copper composite of Example 2.
Fig. 8 is an SEM image of the ceramic-copper composite of Example 2.

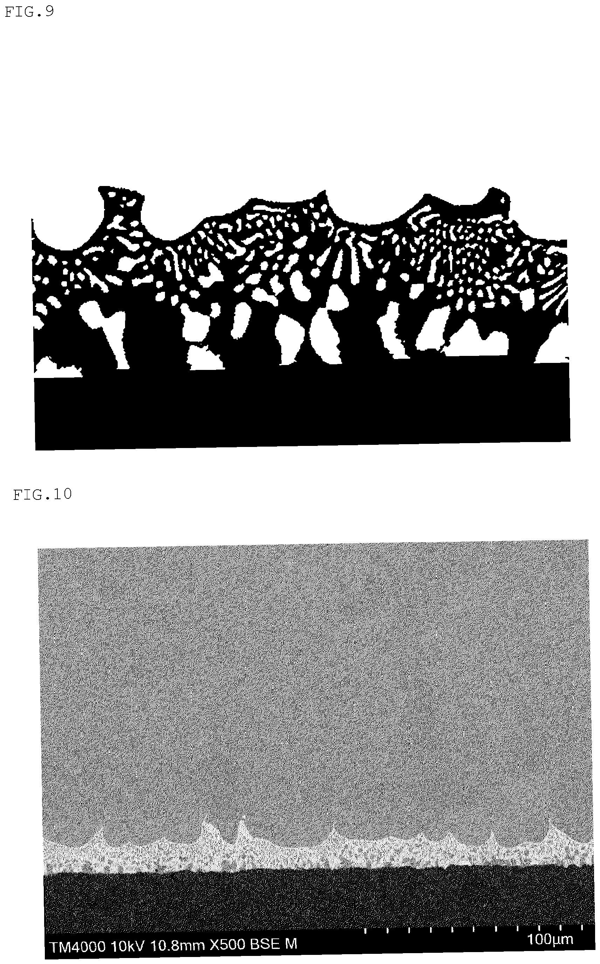

Fig. 9 is a binarized view of the SEM image of the ceramic-copper composite of Example 2.
Fig. 10 is an SEM image of a ceramic-copper composite of Example 3.

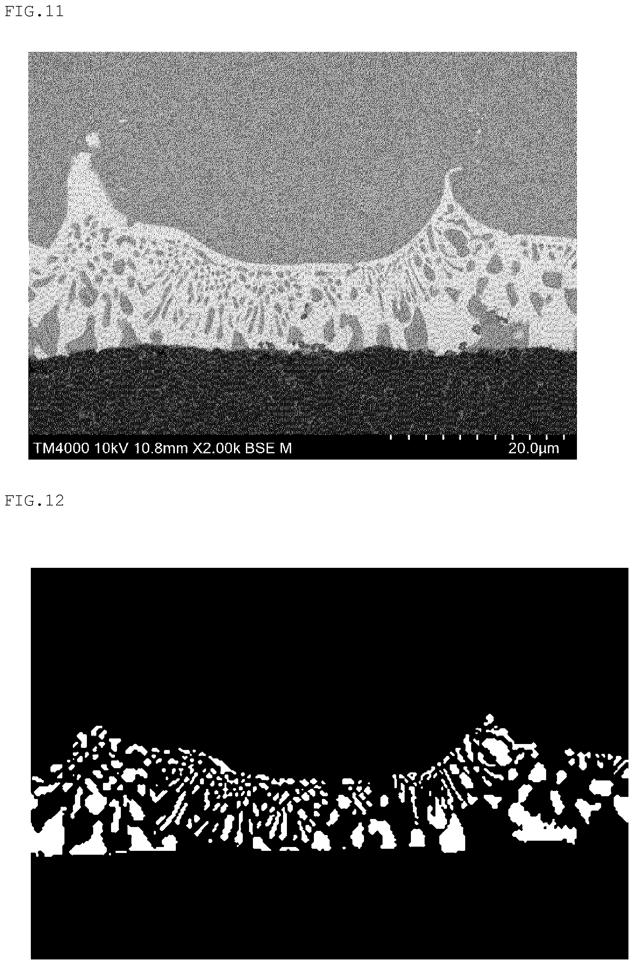

Fig. 11 is an SEM image of the ceramic-copper composite of Example 3.
Fig. 12 is a binarized view of the SEM image of the ceramic-copper composite of Example 3.

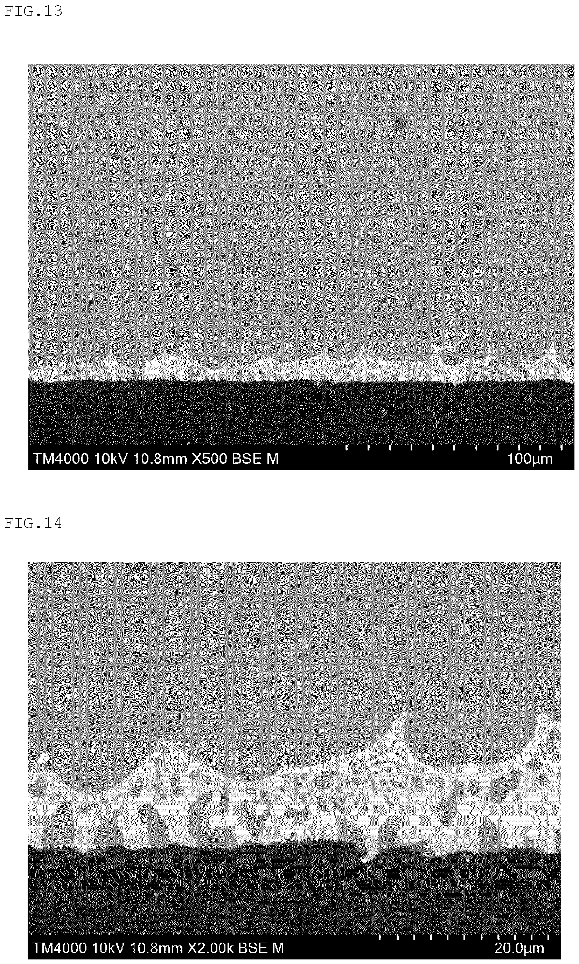

Fig. 13 is an SEM image of a ceramic-copper composite of Example 4.
Fig. 14 is an SEM image of the ceramic-copper composite of Example 4.

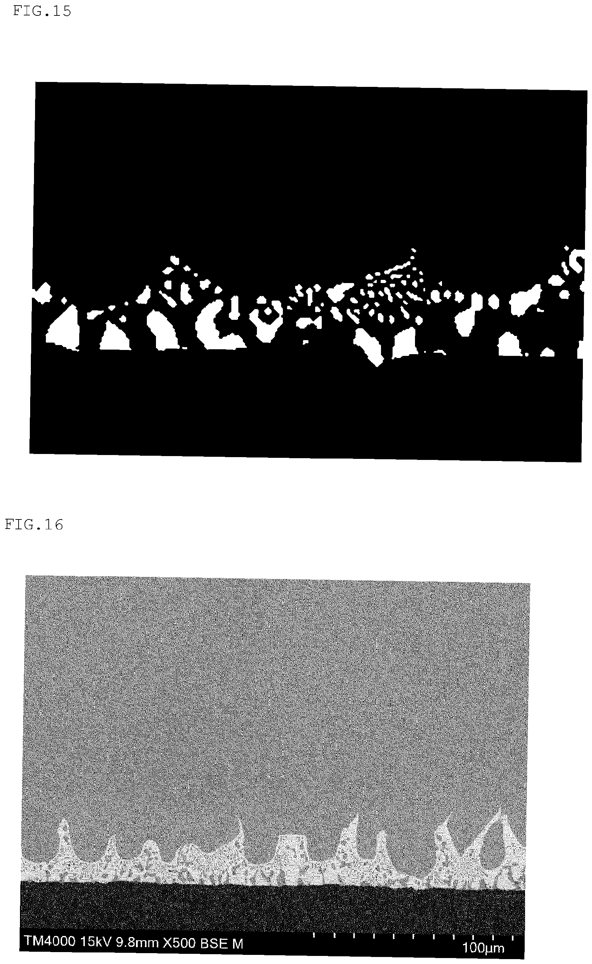

Fig. 15 is a binarized view of the SEM image of the ceramic-copper composite of Example 4.
Fig. 16 is an SEM image of a ceramic-copper composite of Example 5.

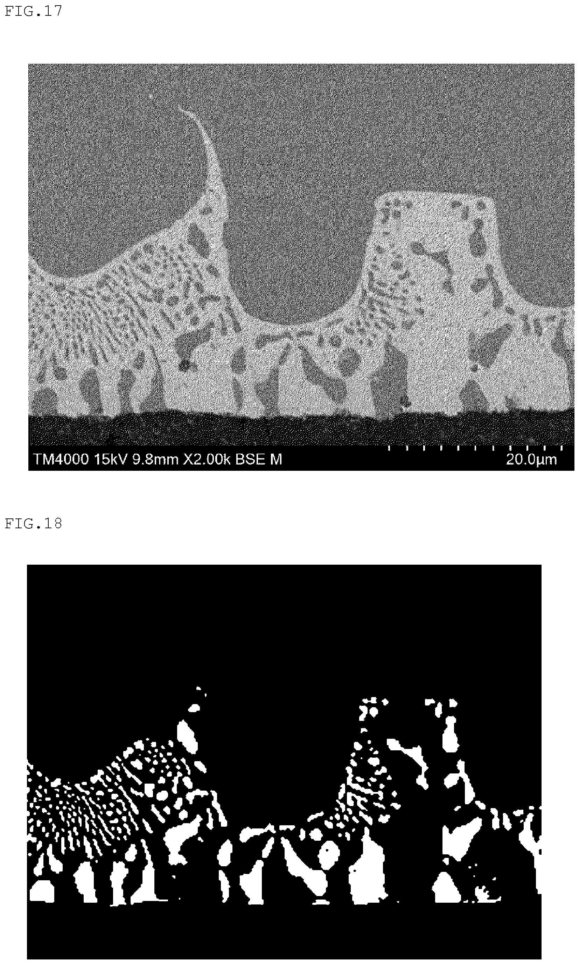

Fig. 17 is an SEM image of the ceramic-copper composite of Example 5.
Fig. 18 is a binarized view of the SEM image of the ceramic-copper composite of Example 5.

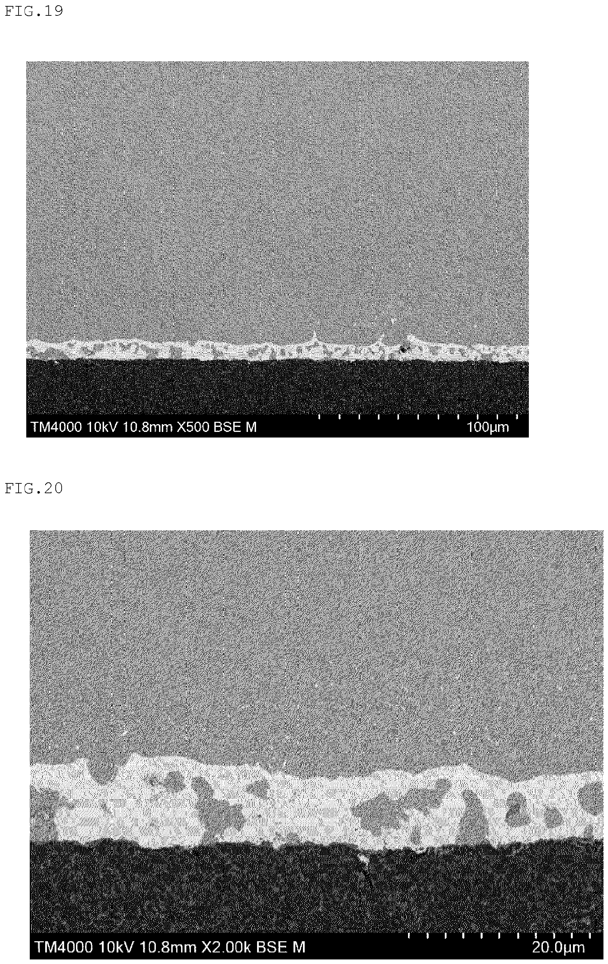

Fig. 19 is an SEM image of a ceramic-copper composite of Comparative Example 1.
Fig. 20 is an SEM image of the ceramic-copper composite of Comparative Example 1.

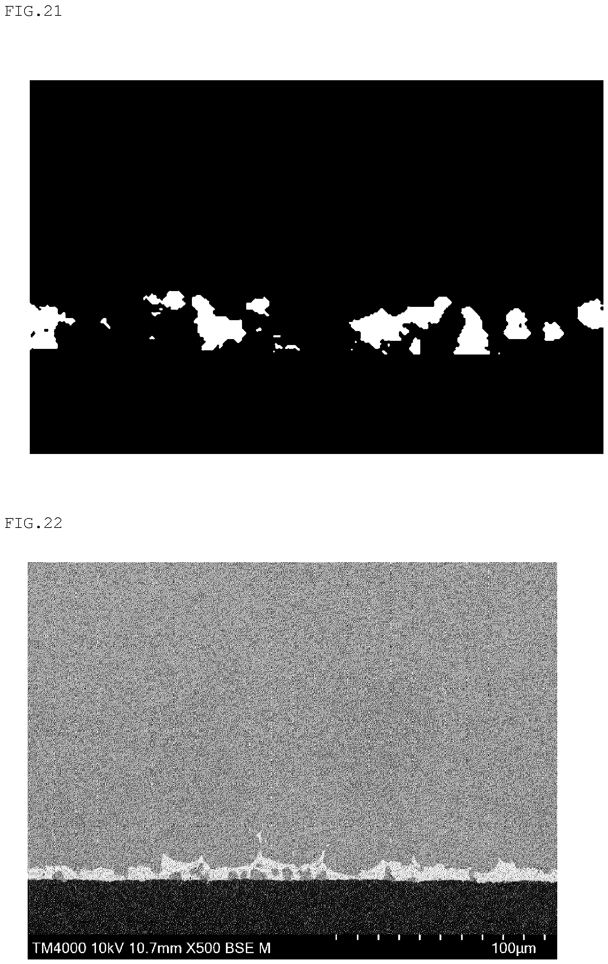

Fig. 21 is a binarized view of the SEM image of the ceramic-copper composite of Comparative Example 1.
Fig. 22 is an SEM image of a ceramic-copper composite of Comparative Example 2.

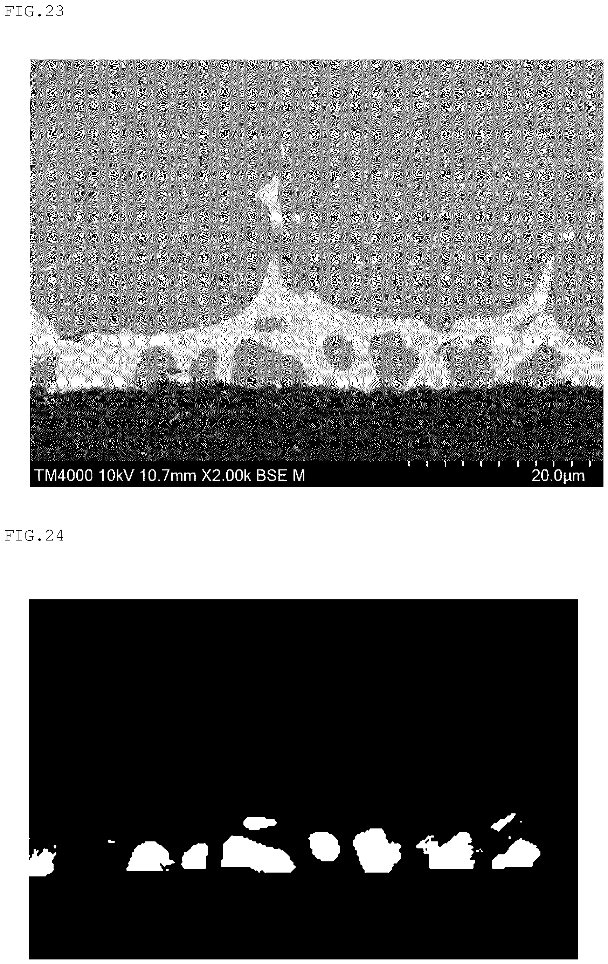

Fig. 23 is an SEM image of the ceramic-copper composite of Comparative Example 2.
Fig. 24 is a binarized view of the SEM image of the ceramic-copper composite of Comparative Example 2.

DESCRIPTION OF EMBODIMENTS

Hereinafter, embodiments of the present invention will be described with reference to the drawings. In all drawings, the same components are denoted by the same reference numerals, and description thereof will not be repeated. In addition, the figure is a schematic diagram and does not correspond to the actual dimensional ratio.

In the present embodiment, the front-back, left-right, and up-down directions are defined as shown in the figure. However, the definition is merely provided for convenience in order to briefly describe relative relationships among the components. Therefore, it is not intended to limit the direction in which the product according to the present invention is manufactured or used.

A ceramic-copper composite of the present embodiment will be outlined.

The ceramic-copper composite is a flat plate-shaped member including a ceramic layer, a copper layer, and a brazing material layer interposed between the ceramic layer and the copper layer and containing Ag and Sn or In.

In at least one of cut surfaces obtained when the ceramic-copper composite is cut along a plane perpendicular to a main surface of the ceramic-copper composite, an uneven portion is formed on a copper layer side of the brazing material layer, and a plurality of Cu-rich phases are present in a state of being separated from each other in at least one projecting portion.

According to the findings of the present inventor, it has been found that the heat cycle characteristics of the ceramic-copper composite can be improved by forming the plurality of Cu-rich phases in a region of the brazing material layer which becomes convex toward the copper layer side.

Although the detailed mechanism is not clear, it is considered that the presence of the plurality of Cu-rich phases in the projecting portion improves the peel strength at an interface between the brazing material layer and the copper layer, and consequently, the occurrence of peeling between the brazing material layer and the copper layer is suppressed after a heat cycle test, thereby improving the heat cycle characteristics.

Such a structure can be obtained by appropriately selecting bonding conditions of the ceramic-copper composite, such as adopting conditions of rapid heating and rapid cooling under a nitrogen atmosphere and setting a high heating peak temperature. Although the detailed mechanism is not clear, it is supposed that an interface of an Ag-rich phase the brazing material layer moves toward an inside of the copper layer to form a projected Ag-rich phase, and Cu atoms diffused from the copper layer or Cu atoms contained in a brazing material form the plurality of Cu-rich phases in the projecting portion composed of the Ag-rich phase.

By forming a circuit pattern on the copper layer using the ceramic-copper composite of the present embodiment, a ceramic circuit board having a copper heat radiating plate and a copper circuit board on both sides of the ceramic layer through the brazing material layer is realized. Such a ceramic circuit board can improve the heat cycle characteristics.

Using such a ceramic circuit board, an electronic component module including the ceramic circuit board, an electronic component provided on the copper circuit board of the ceramic circuit board, and a heat sink provided on the copper heat radiating plate of the ceramic circuit board can be realized. By using the ceramic circuit board described above, it is possible to improve the connection reliability of the electronic component module.

A ceramic-copper composite 100 can be applied to various applications, and one of them can be applied to an in-vehicle power module that requires high reliability.

Hereinafter, the ceramic-copper composite of the present embodiment will be described in detail.

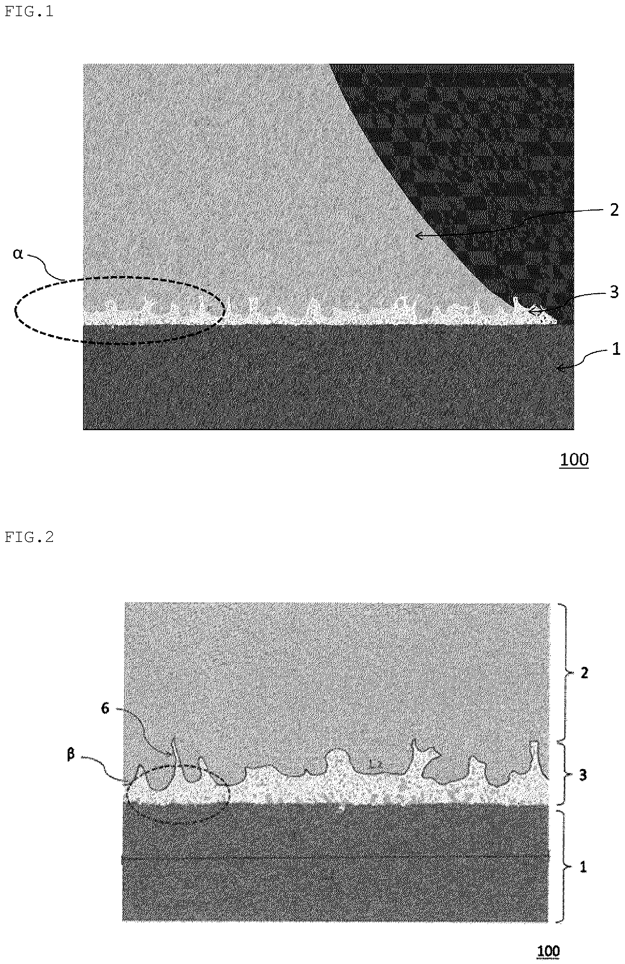

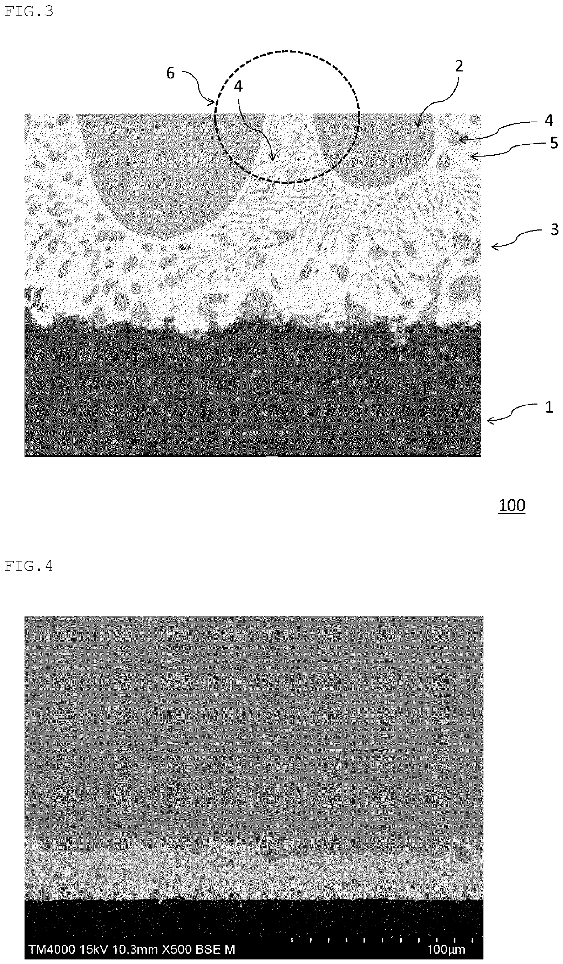

Fig. 1 is a cross-sectional view of bonding of an outer portion in an example of the ceramic-copper composite 100, Fig. 2 is an enlarged view of an $\alpha$ region of Fig. 1, and Fig. 3 is an enlarged view of a $\beta$ region of Fig. 2. In Fig. 1, black indicates a ceramic layer 1, gray indicates a copper layer 2, and white indicates a brazing material layer 3. In Fig. 3, in the brazing material layer 3, white indicates an Ag-rich phase 5 and gray indicates a Cu-rich phase 4.

The ceramic-copper composite 100 shown in Fig. 1 has a structure in which the ceramic layer 1, the brazing material layer 3, and the copper layer 2 are laminated in this order.

As the ceramic layer 1, for example, nitride-based ceramics such as silicon nitride and aluminum nitride, oxide-based ceramics such as aluminum oxide and zirconium oxide, carbide-based ceramics such as silicon carbide, and boride-based ceramics such as lanthanum boride can be used. Among these, non-oxide-based ceramics such as aluminum nitride and silicon nitride are suitable from the viewpoint of metal bondability, and silicon nitride is preferable from the viewpoint of excellent mechanical strength and fracture toughness.

Although a thickness of the ceramic layer 1 is not particularly limited, the thickness is generally about 0.1 mm to 3.0 mm, and in particular, in consideration of heat radiating characteristics and thermal resistance reduction, it is preferably 0.2 mm to 1.2 mm or less, and more preferably 0.25 mm to 1.0 mm or less.

In the present specification, the term "to" means to include an upper limit value and a lower limit value unless otherwise specified.

The copper layer 2 is not particularly limited, and can be formed of, for example, a copper plate. The material used for the copper plate is preferably pure copper. Although a thickness of the copper plate is not particularly limited, the thickness is generally 0.1 mm to 1.5 mm, and in particular, from the viewpoint of heat radiation properties, it is preferably equal to or more than 0.3 mm, and more preferably equal to or more than 0.5 mm.

As a method of forming a circuit pattern on the copper layer 2, for example, a method of forming the circuit pattern by forming an etching mask and performing an etching treatment after bonding a metal plate (for example, a copper plate) on the ceramic layer 1 by using the brazing material layer 3 may be used.

The brazing material layer 3 is composed of a brazing material containing Ag and Sn or In.

The brazing material may contain at least any combination of Ag and Sn, Ag and In, or Ag, Sn, and In. The brazing material may contain elements other than these elements, and may contain, for example, Cu or Ti.

In at least one of cut surfaces (Figs. 1 to 3) obtained when the ceramic-copper composite 100 is cut along a plane perpendicular to a main surface of the ceramic-copper composite 100, an uneven portion is formed on the copper layer 2 side of the brazing material layer 3. A plurality of the Cu-rich phases 4 are present in a state of being separated from each other in at least one projecting portion 6 in the uneven portion.

The cut surfaces of Figs. 1 to 3 show a region outside, that is, in the vicinity of an end portion, of the ceramic-copper composite 100.

For example, the projecting portion 6 of the brazing material layer 3 may be defined as a portion which passes a position of 1/2 of an average thickness of the brazing material layer 3 from an interface between the ceramic layer 1 and the brazing material layer 3 toward the vertical direction on the copper layer 2 side in the cross-sectional view. In addition, a recessed portion in the uneven portion of the brazing material layer 3 may be defined as a portion that does not pass the position of 1/2 of the average thickness of the brazing material layer 3.

Here, regarding the average thickness of the brazing material layer 3, a thickness from the interface between the ceramic layer 1 and the brazing material layer 3 to an interface between the brazing material layer 3 and the copper layer 2 may be measured by the following image observation, and an average value of the maximum thickness and the minimum thickness may be used.

The image observation in the present embodiment may be performed as follows.

An SEM image at any position at a bonding interface of the cross section of the ceramic-copper composite is obtained by using a scanning electron microscope. Using the obtained SEM image, a region of 40 $\mu$m $\times$ 60 $\mu$m is optionally observed for 3 visual fields in the vicinity of the center of the plate thickness cross section in the center of the longitudinal direction.

For values calculated by the observation visual field, an average value obtained by averaging the values measured by the observation for 3 visual fields may be used.

By the image observation, the length of the observation visual field in the plate width direction and the length of the line segment at the interface between the brazing material layer 3 and the copper layer 2 are obtained, and the respective lengths are defined as L1 and L2 as shown in Fig. 3.

In this case, a ratio of L1 to L2 (L2/L1) may be, for example, 1.25 to 5.0, and more preferably 1.30 to 3.0. Since it is supposed that the interfacial bonding between the brazing material layer 3 and the copper layer 2 is enhanced by setting L2/L1 to be equal to or more than the above lower limit value, the heat cycle characteristics can be improved.

The brazing material layer 3 may have a plurality of the projecting portions 6 intruding into the copper layer 2. The plurality of projecting portions 6 need only be formed at least in the vicinity of the end portion of the ceramic-copper composite 100, and may be formed both in the vicinity of the end portion and in the inside thereof.

Although the number of the projecting portions 6 of the brazing material layer 3 is not particularly limited, the brazing material layer 3 may be configured such that there are more projecting portions 6 in the outer region in the vicinity of the end portion than in the inner region. As a result, when the ceramic-copper composite 100 is viewed in the direction perpendicular to the main surface, the occurrence of peeling, cracking, and the like in the vicinity of an outer peripheral portion during the heat cycle test can be suppressed.

Although the Cu-rich phase 4 present in the projecting portion 6 of the brazing material layer 3 may be formed in various shapes such as substantially spherical and substantially elliptical shapes in the cross-sectional view, at least one or more of the Cu-rich phases 4 may be formed in a stripe shape. These may be used alone or in combination of two or more. In addition, a plurality of the stripe-shaped Cu-rich phases 4 may be present in the same projecting portion 6, and may form a stripe pattern in the same projecting portion 6 while being separated from each other.

An aspect ratio of one of the Cu-rich phases 4 constituting the stripe may be, for example, more than 1 and equal to or less than 10, and preferably equal to or more than 2 and equal to or less than 9. Thereby, the heat cycle characteristics can be improved.

A number density of the Cu-rich phase 4 in the projecting portion 6 of the brazing material layer 3 is, for example, equal to or more than 0.1 pieces/$\mu$m$^2$ and equal to or less than 20 pieces/$\mu$m$^2$, and preferably equal to or more than 0.2 pieces/$\mu$m$^2$ and equal to or less than 10 pieces/$\mu$m$^2$. The heat cycle characteristics can be improved by setting the number density of the Cu-rich phase 4 to be equal to or more than the above lower limit value.

For the number density of the Cu-rich phase 4, an area of the brazing material layer 3 is measured using an image analysis software (Image-pro plus) by performing analysis using a figure obtained by binarizing the SEM image used in the above image observation by an image analysis software GIMP2 (threshold value 90), and the number density (pieces/$\mu$m$^2$) of the Cu-rich phase 4 is obtained by the following equation.

$$\text{Equation: [Number density of Cu-rich phase 4]} = \text{[Number of Cu-rich phase 4]/[Area of brazing material layer 3]}$$

The Cu-rich phase in the brazing material layer 3 may include, for example, a fine phase of 0.3 $\mu$m or more and less than 1.0 $\mu$m and a coarse phase of 1.0 $\mu$m or more and 7.5 $\mu$m or less. The presence of the fine phase and the coarse phase allows the Cu-rich phase 4 to be present in the projecting portion 6, and the number density of the Cu-rich phase 4 in the projecting portion 6 can be increased.

The brazing material layer 3 need only have the plurality of Cu-rich phases 4 at least in the projecting portion 6, and may or may not have the Cu-rich phases 4 in regions other than the projecting portions 6.

The brazing material layer 3 is composed of the Ag-rich phase 5. The Ag-rich phase 5 may be continuously formed in the projecting portion 6 of the brazing material layer 3. A plurality of the Cu-rich phases 4 may be discontinuously scattered inside the Ag-rich phase 5 present in the projecting portion 6.

The Ag-rich phase 5 may be formed at least partially or continuously at an outer edge portion of the projecting portion 6, that is, at a portion of the projecting portion 6 in contact with the interface between the brazing material layer 3 and the copper layer 2. That is, in the projecting portion 6, the Cu-rich phase 4 may be discretely present in a region surrounded by the Ag-rich phase 5.

In the Cu-rich phase 4, the term "Cu-rich" may be defined as mainly containing a Cu solid solution. An abundance ratio of Cu in the Cu-rich phase 4 of the projecting portion 6 need only be, for example, equal to or more than 80% by mass.

In the Ag-rich phase 5, the term "Ag-rich" may be defined as mainly containing an Ag solid solution. An abundance ratio of Ag in the Ag-rich phase 5 of the projecting portion 6 need only be, for example, equal to or more than 80% by mass.

Content ratios of Cu and Ag are quantitatively analyzed using an electron probe X-ray microanalyzer (EPMA).

A diffusion distance of Ag, which is a component of the brazing material layer 3, is, for example, 10 $\mu$m to 50 $\mu$m, and preferably 15 $\mu$m to 45 $\mu$m.

Here, the term "diffusion distance of Ag" can be defined as a distance between a surface of the ceramic layer 1 and a portion where Ag is diffused farthest from the surface of the ceramic layer 1 in the surface direction of the copper layer 2 (the direction perpendicular to the main surface of the ceramic-copper composite 100). The diffusion distance of Ag does not always match a thickness of the continuous brazing material layer.

The diffusion distance of Ag is the largest of the diffusion distances of Ag measured in each of 3 randomly selected and observed visual fields (range of 250 $\mu$m in the horizontal direction of the bonding interface) at a magnification of 500x from the cross section (the plate thickness cross section in the center of the longitudinal direction) of the ceramic-copper composite 100 by a scanning electron microscope without overlapping.

In addition, the ceramic-copper composite 100 may have a bonding layer containing Ti, which is interposed between the ceramic layer 1 and the brazing material layer 3.

A bonding void fraction of such a ceramic-copper composite 100 may be, for example, equal to or less than 1.0%. Thereby, peeling of the copper plate during the heat cycle can be suppressed.

The brazing material layer 3 may be configured such that a part thereof does not have a crawling portion configured to crawl up a side surface of the copper layer 2.

Next, a method for producing the ceramic-copper composite 100 will be described.

One method for producing the ceramic-copper composite 100 includes a step of preparing a flat plate-shaped laminate in which a ceramic layer, a brazing material containing Ag, and a copper layer are laminated, and a step of bonding the laminate. As a result the flat plate-shaped ceramic-copper composite 100 including the ceramic layer 1, the copper layer 2, and the brazing material layer 3 interposed between the ceramic layer 1 and the brazing material layer 3 and containing Ag is obtained.

By increasing a compounding ratio of Ag powder in a brazing material compounding Ag/Cu ratio from 72% by mass: 28% by mass, which is a eutectic composition of Ag and Cu, it is possible to prevent coarsening of the Cu-rich phase and to form a brazing material layer structure in which the Ag-rich phase continues. The compounding amount of Ag powder is large and the compounding amount of Cu powder is small, the Ag powder does not completely dissolve during bonding and remains as a bonding void. Further, Sn or In contained in the brazing material powder is a component for reducing a contact angle of the brazing material with respect to the ceramic board and improving the wettability of the brazing material. In a case where the amount thereof is too small, the wettability with respect to the ceramic board is lowered, which may lead to poor bonding, and in a case where the amount thereof is too large, the Ag-rich phase in the brazing material layer is discontinuous due to the Cu-rich phase and this phenomenon becomes an origin of breaking in the brazing material, which may reduce the heat cycle characteristics of the ceramic circuit board.

Therefore, the compounding ratios of Ag powder, Cu powder, Sn powder, or In powder are: 85.0 to 95.0 parts by mass, preferably 88.0 to 92.0 parts by mass, and more preferably. 88.5 to 91.0 parts by mass of Ag powder; 5.0 to 13.0 parts by mass, preferably 6.0 to 12.0 parts by mass, and more preferably 7.0 to 11.0 parts by mass of Cu powder; and 0.4 to 2.0 parts by mass, and preferably 0.5 to 1.5 parts by mass of Sn powder or In powder.

As a method of mixing the brazing material raw materials, it is preferable that a metal powder, an organic solvent, and a binder are compounded, and mixed using a grinding mixer, a rotating and revolving mixer, a planetary mixer, a three-roll mill, or the like, to form a paste. Generally, as the organic solvent, methyl cellosolve, ethyl cellosolve, isophorone, toluene, ethyl acetate, terpineol, diethylene glycol monobutyl ether, texanol, and the like are used, and as the binder, a polymer compound such as polyisobutyl methacrylate, ethyl cellulose, methyl cellulose, or an acrylic resin is used.

As a method of applying the brazing material paste to both surfaces of the ceramic board, there are a roll coating method, a screen printing method, a transfer method, and the like, but in order to uniformly apply the brazing material, the screen printing method is preferable. In the screen printing method, in order to uniformly apply the brazing material paste, it is preferable to control the viscosity of the brazing material paste to 5 to 20 Pa·s. By compounding the amount of the organic solvent in a range of 5% to 17% by mass and the amount of the binder in a range of 2% to 8% by mass in the brazing material paste, a brazing material paste having excellent printability can be obtained.

In the above bonding step, the ceramic layer 1 and the brazing material layer 3 are bonded to each other with the brazing material interposed therebetween. In the bonding step, the temperature may be raised at a temperature rising rate of 20 °C/min or higher and 150 °C/min or lower under a nitrogen atmosphere, and then the laminate may be heated at a temperature of 750°C or higher and 900°C or lower.

The lower limit of the temperature rising rate is equal to or higher than 20 °C/min, preferably equal to or higher than 25 °C/min, and more preferably equal to or higher than 30 °C/min. The temperature rising rate may be an average temperature rising rate from 20°C to 750°C.

A peak temperature of the heating temperature in the bonding step may be equal to or higher than 750°C, preferably equal to or higher than 800°C, and more preferably equal to or higher than 820°C.

It is generally known that the bonding step of the ceramic circuit board is performed under a vacuum atmosphere.

However, under a vacuum atmosphere, rapid heating of 20 °C/min or higher cannot be performed, and the temperature rising rate is usually 5 °C/min.

On the other hand, in the present embodiment, by selecting nitrogen gas from inert gas as a heat medium, the rapid heating as described above becomes possible.

In addition, in the bonding step, in the bonding step, after the laminate is heated, the laminate may be cooled at a temperature lowering rate of 10 °C/min or higher and 100 °C/min or lower.

The lower limit of the cooling rate is, for example, equal to or higher than 10 °C/min, preferably equal to or higher than 13 °C/min, and more preferably equal to or higher than 15 °C/min. The cooling rate may be an average cooling rate from 750°C to 20°C.

An oxygen concentration in the nitrogen atmosphere in the bonding step is, for example, equal to or less than 500 ppm, preferably equal to or less than 200 ppm, and more preferably equal to or less than 120 ppm. As a result, the connection state of the end portion of the ceramic-copper composite 100 can be improved.

In the present embodiment, for heating in the bonding step, as an example, a structure in which two or more flat plate-shaped laminates are stacked may be heated using a nitrogen heating furnace. By using the nitrogen heating furnace, it is possible to appropriately control the conditions of the rapid heating, the rapid cooling, or the nitrogen atmosphere.

In order to form a circuit pattern on the copper layer 2 of the ceramic-copper composite 100, an etching resist may be applied to the copper layer 2 for etching.

There is no particular limitation on the etching resist, and for example, a generally used ultraviolet curing type or thermosetting type can be used. A method of applying the etching resist is not particularly limited, and a known application method such as a screen printing method can be adopted.

A surface of the copper layer 2 on which the circuit pattern is formed can be subjected to electroless Ni plating, Au flash plating, substitution type Ag plating, or the like, as necessary. After the surface is smoothed by grinding, physical polishing, chemical polishing, or the like without plating, a rust preventive agent can be applied.

Although the embodiments of the present invention have been described above, these are examples of the present invention, and various configurations other than those described above can be adopted. In addition, the present invention is not limited to the above-described embodiment, and modifications, improvements, and the like within the range in which the object of the present invention can be achieved are included in the present invention.

Examples

Hereinafter, the present invention will be described in detail with reference to Examples, but the present invention is not limited to the description of these Examples.

<Manufacturing of Ceramic-Copper Composite>

(Example 1)

Onto both main surfaces of a silicon nitride substrate having a thickness of 0.32 mm, an active metal brazing material containing 3.5 parts by mass of titanium hydride powder(TCH-100 manufactured by Toho Technical Service Co., Ltd.) based on a total of 100 parts by mass of 89.5 parts by mass of Ag powder (Ag-HWQ; average particle diameter D50: 2.5 $\mu$m; specific surface area: 0.4 $m^2$/g; manufactured by Fukuda Metal Foil % Powder Co., Ltd.), 9.5 parts by mass of Cu powder (Cu-HWQ; average particle diameter D50: 3.0 $\mu$m; specific surface area: 0.4 $m^2$/g; manufactured by Fukuda Metal Foil % Powder Co., Ltd.), and 1.0 part by mass of Sn powder (Sn-HPN; average particle diameter D50: 3 $\mu$m; specific surface area: 0.1 $m^2$/g; manufactured by Fukuda Metal Foil % Powder Co., Ltd.) was applied by a screen printing method, such that the applied amount was 8 mg/$cm^2$.

Thereafter, a metal plate for forming a circuit was stacked on one surface of the silicon nitride substrate and a metal plate for forming a heat radiating plate (both the metal plates being C1020 oxygen-free copper plates having a thickness of 0.5 mm) was stacked on the other surface, to obtain a laminate.

Using a nitrogen heating furnace, a temperature of the obtained laminate was raised from 25°C to 870°C at a temperature rising rate of 90 °C/min under a nitrogen atmosphere with an oxygen concentration of 100 ppm, and kept at 870°C (bonding temperature) for 18 minutes (bonding time), and then cooled to 25°C at a temperature lowering rate of 15 °C/min (bonding step).

An etching resist was printed on the bonded copper plate and the resultant copper plate was etched with a ferric chloride solution to form a circuit pattern, thereby obtaining a ceramic-copper composite.

(Examples 2 to 5)

A ceramic-copper composite was obtained in the same manner as in Example 1 except that the bonding step was changed to the bonding conditions shown in Table 1.

(Comparative Examples 1 and 2)

A ceramic-copper composite was obtained in the same manner as in Example 1 except that the bonding step was changed to the bonding conditions shown in Table 1 in a heating furnace in a vacuum of 1.0 $\times$ $10^{-3}$ Pa or less.

[Table 1]

| | Bonding process | Brazing material compounding | | | | Bonding condition | | | | | Cu-rich phase structure 1 | Cu-rich phase structure 2 | Cu-rich phase structure 3 |
|---|---|---|---|---|---|---|---|---|---|---|---|---|---|
| | | Ag | Cu | Sn | TiH₂ | Temperature rising rate | Bonding temperature | Bonding time | Temperature lowering rate | Oxygen concentration | | | |
| | | (parts) | (parts) | (parts) | (parts) | (°C/min) | (°C) | (minutes) | (°C/min) | (ppm) | | | |
| Example 1 | Nitrogen continuous bonding | 89.5 | 9.5 | 1 | 3.5 | 90 | 870 | 18 | 15 | 100 | Fig. 4 | Fig. 5 | Fig. 6 |
| Example 2 | Nitrogen continuous bonding | 89.5 | 9.5 | 1 | 3.5 | 90 | 870 | 12 | 15 | 100 | Fig. 7 | Fig. 8 | Fig. 9 |
| Example 3 | Nitrogen continuous bonding | 89.5 | 9.5 | 1 | 3.5 | 90 | 870 | 12 | 15 | 110 | Fig. 10 | Fig. 11 | Fig. 12 |
| Example 4 | Nitrogen continuous bonding | 89.5 | 9.5 | 1 | 3.5 | 90 | 870 | 9 | 15 | 110 | Fig. 13 | Fig. 14 | Fig. 15 |
| Example 5 | Nitrogen continuous bonding | 89.5 | 9.5 | 1 | 3.5 | 45 | 890 | 27 | 30 | 10 | Fig. 16 | Fig. 17 | Fig. 18 |
| Comparative Example 1 | Vacuum batch bonding | 89.5 | 9.5 | 1 | 3.5 | 5 | 790 | 20 | 3 | – | Fig. 19 | Fig. 20 | Fig. 21 |
| Comparative Example 2 | Vacuum batch bonding | 88.5 | 8.5 | 3 | 3.5 | 5 | 790 | 20 | 3 | – | Fig. 22 | Fig. 23 | Fig. 24 |

[Table 1 continued]

| | Cu-rich phase structure shape | Cu-rich phase structure shape | Cu-rich phase structure shape | Cu-rich phase | | | Cu-rich phase Fine phase size (0.3 to 1.0 μm) | Cu-rich phase Coarse phase size (1.0 to 7.5 μm) | Cu-rich phase CU abundance ratio | Diffusion distance of Ag | Bonding void fraction | Heat cycle |
|---|---|---|---|---|---|---|---|---|---|---|---|---|
| | | | | Aspect ratio | Number density | L1/L2 ratio | | | | | | |
| | Unevenness | Cu-rich phase in projecting portion | | | (pieces/μm²) | | (Presence or absence) | (Presence or absence) | % by mass | (μm) | (area%) | % |
| Example 1 | Present | Present | At least one has stripe shape | 2.1 | 0.6 | 2.00 | Present | Present | 80% by mass or more | 24 | 0.3 | 0.2 |
| Example 2 | Present | Present | At least one has stripe shape | 1.9 | 0.3 | 1.60 | Present | Present | 80% by mass or more | 20 | 0.2 | 0.1 |
| Example 3 | Present | Present | At least one has stripe shape | 2.3 | 0.6 | 1.38 | Present | Present | 80% by mass or more | 18 | 0.3 | 0.0 |
| Example 4 | Present | Present | At least one has stripe shape | 1.9 | 0.3 | 1.33 | Present | Present | 80% by mass or more | 18 | 0.3 | 0.0 |
| Example 5 | Present | Present | At least one has stripe shape | 2.3 | 0.2 | 2.05 | Present | Present | 80% by mass or more | 22 | 0.1 | 0.2 |
| Comparative Example 1 | Absent | Absent | Absent | – | 0.0 | 1.05 | Absent | Present | 80% by mass or more | 20 | 0.3 | 0.3 |
| Comparative Example 2 | Present | Absent | Absent | – | 0.0 | 1.22 | Absent | Present | 80% by mass or more | 21 | 0.2 | 0.4 |

The obtained ceramic-copper composite was evaluated based on the following evaluation items.

(SEM Image Observation)

Cut surfaces of the ceramic-copper composite of Examples 1 to 5 and Comparative Examples 1 and 2 were observed by a scanning electron microscope to obtain SEM images. In the SEM image, black indicates a silicon nitride substrate, white indicates a brazing material layer, and gray indicates a copper plate.

In Table 1, a Cu-rich phase structure 1 shows an SEM image at a magnification of 500x, a Cu-rich phase structure 2 shows an SEM image at a magnification of 2000x, and a Cu-rich phase structure 3 shows a figure obtained by binarizing an SEM image at a magnification of 2000x, by an image analysis software GIMP2 (threshold value 90) .

<Observation of Cu-Rich Phase in Brazing Material Layer Structure>

The Cu-rich phase in the brazing material layer structure was evaluated by observing, using a scanning electron microscope (JSM-6380 manufactured by JEOL Ltd.), 3 visual fields at a magnification of 2000x, the visual fields being 40 $\mu$m in length and 60 $\mu$m in width in the vicinity of the center of the plate thickness cross section in the center of the longitudinal direction, in a reflected-electron image at any position at the bonding interface in the cross section of the ceramic-copper composite. By this method, a Cu-rich phase having a particle size of 0.1 $\mu$m or more can be observed. In a case where the observation magnification is set to a magnification that is too high, the visual field becomes narrow, and a sufficient number of Cu-rich phases cannot be observed. Conversely, in a case where the magnification is too low, Cu-rich phases less than 1 $\mu$m cannot be observed, so that the magnification was set to 2000x.

(Structure Shape)

Based on the image observation described above, the presence or absence of recess and projection of the brazing material layer structure and the presence or absence of the Cu-rich phase in the projecting portion were evaluated based on the following criteria.

An average thickness of the brazing material layer was obtained from an average value of the maximum thickness and the minimum thickness obtained by measuring the thickness from the interface between the silicon nitride substrate and the brazing material layer to the interface between the brazing material layer and the copper plate. The measurement was performed in 3 visual fields, and the average of the total 3 visual fields was used.

In the region of the brazing material layer shown in the SEM image, when there is a portion which passes a position of 1/2 of the average thickness of the brazing material layer from the interface between the silicon nitride substrate and the brazing material layer toward the vertical direction on the copper plate side, it was determined that there is a projecting portion in the brazing material layer, and when there is a portion which does not pass the position of 1/2 of the average thickness of the brazing material layer, it was determined that there is a recessed portion in the brazing material layer.

In addition, when there is a projecting portion in the brazing material layer, the Cu-rich phase was observed in the inner region of the projecting portion, and the presence or absence and the shape of the Cu-rich layer were evaluated.

(Fine Phase and Coarse Phase)

Based on the image observation described above, the presence or absence of a fine phase of 0.3 $\mu$m or more and less than 1.0 $\mu$m and a coarse phase of 1.0 $\mu$m or more and 7.5 $\mu$m or less was examined. The results are shown in Table 1.

An abundance ratio of Cu in the Cu-rich phase was quantitatively analyzed using an electron probe X-ray microanalyzer (EPMA).

(L1 and L2)

Based on the image observation described above, the length L1 of the observation visual field in the plate width direction and the length L2 of the line segment at the interface between the brazing material layer and the copper layer were measured, to obtain L1/L2. The results are shown in Table 1.

<Evaluation of Cu-Rich Phase in Brazing Material Layer Structure>

A figure obtained by binarizing the SEM image obtained by the above method by an image analysis software GIMP2 (threshold value 90) was analyzed, and an aspect ratio and a number density of the Cu-rich phase were measured.

As the software for image analysis, an image processing software (Image-Pro Plus) manufactured by Media Cybernetics, Inc., was used.

The Cu-rich phase in the brazing material layer structure varies in particle size from 0.3 $\mu$m to several $\mu$m. The Cu-rich phase of a fine phase having a particle size of 0.1 $\mu$m or more and less than 1.0 $\mu$m, which can be observed by a scanning electron microscope, was analyzed as an object of the aspect ratio and the number density. An average size of the Cu-rich phase was an average value observed after observing three visual fields and measuring the center-of-gravity diameters of all the Cu-rich phases observed.

For the number density of the Cu-rich phase, an area of the brazing material layer structure was measured using an image analysis software (Image-pro plus) manufactured by Media Cybernetics, Inc. and the number density of the Cu-rich phase was obtained by the following Equation (I).

$$\text{Number density of Cu-rich phase (pieces/}\mu\text{m}^2\text{)} = \text{Number of Cu-rich}$$

$$\text{phase/Area of brazing material layer structure ... (I)}$$

(Diffusion Distance of Ag)

After cutting the ceramic-copper composite and performing resin embedding and cross sectional polishing, reflected-electron images of 3 random visual fields (range of 250 $\mu$m in the horizontal direction of the bonding interface) were imaged at a magnification of 500x by a scanning electron microscope, and the shortest distance ($\mu$m) between the silicon nitride substrate and the position of Ag, which is closest to the copper plate surface, in the copper plate was measured.

(Bonding Void Fraction)

An area of a bonding void of the ceramic-copper composite observed by an ultrasonic flaw detector (ES5000 manufactured by Hitachi Power Solutions Co., Ltd.) was measured and divided by an area of a circuit pattern, to obtain a bonding void fraction (area%) .

(Heat Cycle Test)

With one heat cycle defined as being kept, on a hot plate, at 350°C for 5 minutes and at 25°C for 5 minutes, and in a mixed solvent of ethanol and dry ice, at -78°C for 5 minutes and at 25°C for 5 minutes, 15 continuous cycles were performed on the ceramic-copper composite.

Thereafter, the copper plate, the brazing material layer, and the nitride layer were removed by etching, horizontal cracks generated on the surface of the ceramic board were captured by a scanner at a resolution of 600 dpi $\times$ 600 dpi, binarized by an image analysis software GIMP2 (threshold value 140), and calculated, and then a horizontal crack area was divided by a circuit pattern area, to calculate a crack rate (%) after the heat cycle.

The ceramic-copper composite of Examples 1 to 5 showed excellent heat cycle characteristics as compared with Comparative Examples 1 and 2 due to a lower crack rate after the heat cycle in the heat cycle test.

This application claims priority based on Japanese Patent Application No. 2020-009305 filed on January 23, 2020, and the disclosure of which is incorporated herein in its entirety by reference.

REFERENCE SIGNS LIST

1: ceramic layer
2: copper layer
3: brazing material layer
4: Cu-rich phase
5: Ag-rich phase
6: projecting portion
100: ceramic-copper composite

**Claims**

**1.** A ceramic-copper composite having a flat plate shape, comprising:

a ceramic layer;

a copper layer; and

a brazing material layer which is interposed between the ceramic layer and the copper layer and contains Ag and Sn or In,

wherein, in at least one of cut surfaces obtained when the ceramic-copper composite is cut along a plane perpendicular to a main surface of the ceramic-copper composite, an uneven portion is formed on a copper layer side of the brazing material layer, and a plurality of Cu-rich phases are present in a state of being separated from each other in at least one projecting portion.

2. The ceramic-copper composite according to claim 1,
   wherein at least one or more of the Cu-rich phases are formed in a stripe shape.

3. The ceramic-copper composite according to claim 2,
   wherein an aspect ratio of the Cu-rich phase is more than 1 and equal to or less than 10.

4. The ceramic-copper composite according to any one of claims 1 to 3,
   wherein a number density of the Cu-rich phase is equal to or more than 0.1 pieces/$\mu$m$^2$ and equal to or less than 20 pieces/$\mu$m$^2$.

5. The ceramic-copper composite according to any one of claims 1 to 4,
   wherein, in an observation visual field of the cut surface, a ratio (L2/L1) of a length L1 in a plate width direction of the observation visual field to a length L2 of a line segment at an interface between the brazing material layer and the copper layer is equal to or more than 1.25 and equal to or less than 5.0.

6. The ceramic-copper composite according to any one of claims 1 to 5,
   wherein the Cu-rich phase includes a fine phase of 0.3 $\mu$m or more and less than 1.0 $\mu$m and a coarse phase of 1.0 $\mu$m or more and 7.5 $\mu$m or less.

7. The ceramic-copper composite according to any one of claims 1 to 6,
   wherein an abundance ratio of Cu in the Cu-rich phase is equal to or more than 80% by mass.

8. A method for producing a ceramic-copper composite having a flat plate shape and including a ceramic layer, a copper layer, and a brazing material layer which is interposed between the ceramic layer and the copper layer and contains Ag, the method comprising:

   a step of preparing a flat plate-shaped laminate in which the ceramic layer, a brazing material containing Ag, and the copper layer are laminated; and

   a bonding step of heating the laminate at a temperature of 750°C or higher and 900°C or lower after raising a temperature at a temperature rising rate of 20 °C/min or higher and 150 °C/min or lower under a nitrogen atmosphere.

9. The method for producing a ceramic-copper composite according to claim 8,
   wherein, in the bonding step, after the laminate is heated, the laminate is cooled at a temperature lowering rate of 10 °C/min or higher and 100 °C/min or lower.

10. The method for producing a ceramic-copper composite according to claim 8 or 9,
    wherein an oxygen concentration in the nitrogen atmosphere in the bonding step is equal to or less than 500 ppm.

11. The method for producing a ceramic-copper composite according to any one of claims 8 to 10,
    wherein, in the heating in the bonding step, a structure in which two or more flat plate-shaped laminates are stacked is heated using a nitrogen heating furnace.

FIG.1

100

FIG.2

100

FIG.3

100

FIG.4

TM4000 15kV 10.3mm X500 BSE M                    100μm

FIG.5

FIG.6

FIG.7

FIG.8

FIG.9

FIG.10

TM4000 10kV 10.8mm X500 BSE M                          100μm

FIG.11

TM4000 10kV 10.8mm X2.00k BSE M                    20.0μm

FIG.12

FIG.13

TM4000 10kV 10.8mm X500 BSE M                    100μm

FIG.14

TM4000 10kV 10.8mm X2.00k BSE M                  20.0μm

FIG.15

FIG.16

FIG.17

FIG.18

FIG.19

TM4000 10kV 10.8mm X500 BSE M                    100µm

FIG.20

TM4000 10kV 10.8mm X2.00k BSE M                  20.0µm

FIG.21

FIG.22

TM4000 10kV 10.7mm X500 BSE M          100µm

FIG.23

TM4000 10kV 10.7mm X2.00k BSE M          20.0μm

FIG.24

## INTERNATIONAL SEARCH REPORT

| International application No. |
| --- |
| PCT/JP2021/002185 |

**A. CLASSIFICATION OF SUBJECT MATTER**
H05K 1/03(2006.01)i; H05K 1/09(2006.01)i
FI: H05K1/09 C; H05K1/03 630J; H05K1/03 650

According to International Patent Classification (IPC) or to both national classification and IPC

**B. FIELDS SEARCHED**

Minimum documentation searched (classification system followed by classification symbols)
H05K1/03; H05K1/09

Documentation searched other than minimum documentation to the extent that such documents are included in the fields searched

| | |
| --- | --- |
| Published examined utility model applications of Japan | 1922-1996 |
| Published unexamined utility model applications of Japan | 1971-2021 |
| Registered utility model specifications of Japan | 1996-2021 |
| Published registered utility model applications of Japan | 1994-2021 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2018-506496 A (NGK INSULATORS, LTD.) 08 March 2018 (2018-03-08) paragraphs [0029]-[0048], fig. 5 | 1-7 |
| A | paragraphs [0029]-[0048], fig. 5 | 8-11 |
| A | WO 2019/088222 A1 (MITSUBISHI MATERIALS CORP.) 09 May 2019 (2019-05-09) entire text | 1-11 |
| A | WO 2019/022133 A1 (DENKA COMPANY LIMITED) 31 January 2019 (2019-01-31) entire text | 1-11 |
| A | JP 10-145039 A (DENKI KAGAKU KOGYO KABUSHIKI KAISHA) 29 May 1998 (1998-05-29) entire text | 1-11 |

☐ Further documents are listed in the continuation of Box C.  ☒ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 02 April 2021 (02.04.2021) | 13 April 2021 (13.04.2021) |

| Name and mailing address of the ISA/ | Authorized officer |
| --- | --- |
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

INTERNATIONAL SEARCH REPORT

Information on patent family members

International application No.

PCT/JP2021/002185

| Patent Documents referred in the Report | Publication Date | Patent Family | Publication Date |
|---|---|---|---|
| JP 2018-506496 A | 08 Mar. 2018 | US 2017/0323842 A1 paragraphs [0044]-[0066], fig. 5 WO 2017/115461 A1 EP 3398205 A1 | |
| WO 2019/088222 A1 | 09 May 2019 | CN 111225890 A TW 201924496 A | |
| WO 2019/022133 A1 | 31 Jan. 2019 | US 2020/0163210 A1 entire text EP 3661337 A1 CN 110945974 A KR 10-2020-0029480 A | |
| JP 10-145039 A | 29 May 1998 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005101415 A
- JP 2020009305 A